# EUROPEAN PATENT APPLICATION

(11) **EP 2 741 329 A1**
(43) Date of publication of application: **11.06.2014**
(21) Application number: 13195459.6
(22) Date of filing: 03.12.2013
(51) Int. Cl.: H01L 25/075, H01L 33/52, H01L 33/54, H01L 33/62

(54) **Light-emitting device, light-emitting device assembly, and electrode-bearing substrate**

(30) Priority: 10.12.2012 JP 2012269390; 23.05.2013 JP 2013109035
(71) Applicant: NITTO DENKO CORPORATION, Ibaraki-shi, Osaka 567-8680 (JP)
(72) Inventor: Ooyabu, Yasunari, Osaka, 567-8680 (JP); Kitayama, Yoshihiko, Osaka, 567-8680 (JP); Mitani, Munehisa, Osaka, 567-8680 (JP)
(74) Representative: HOFFMANN EITLE

(57) **Abstract**

A light-emitting device assembly includes a substrate, an optical semiconductor element mounted on the surface of the substrate, an encapsulating layer formed on the substrate surface to encapsulate the optical semiconductor element, and an electrode formed on the substrate surface to be electrically connected to the optical semiconductor element. On the substrate, only an encapsulating region and an electrode region are formed, the encapsulating region including the optical semiconductor element and being defined by the encapsulating layer, and the electrode region being defined by the electrode exposed from the encapsulating layer.

## Description

### CROSS-REFERENCE TO RELATED APPLICATION

The present application claims priority from Japanese Patent Application No. 2012-269390 filed on December 10, 2012, and Japanese Patent Application No. 2013-109035 filed on May 23, 2013, the contents of which are hereby incorporated by reference into this application.

### BACKGROUND OF THE INVENTION

### Field of the Invention

The present invention relates to a light-emitting device, a light-emitting device assembly, and an electrode-bearing substrate. In particular, the present invention relates to a light-emitting device, a light-emitting device assembly including a plurality of light-emitting devices, and an electrode-bearing substrate for production thereof.

### Description of Related Art

Light-emitting devices are known to include a substrate, a light-emitting diode (LED) element mounted thereon, an encapsulating layer for encapsulating the LED element, and an electrode provided on the substrate to be connected to the LED for connection between a power source and the LED.

For example, Japanese Unexamined Patent Publication No. 2008-227412 has proposed a light-emitting device including an insulating substrate; a light-emitting element mounted on the center portion thereof; an encapsulator formed on the insulating substrate to encapsulate so as to include the light-emitting element; and a positive electrode external connection land and a negative electrode external connection land that are disposed on the insulating substrate at the outside of the encapsulator in spaced-apart relation.

In the light-emitting device of Japanese Unexamined Patent Publication No. 2008-227412, each of the positive electrode external connection land and the negative electrode external connection land is electrically connected to a light-emitting element through, for example, internal electrodes. Furthermore, by connecting an external connection wire to each of the positive electrode external connection land and the negative electrode external connection land, the positive electrode external connection land and the negative electrode external connection land are electrically connected to the power source.

### SUMMARY OF THE INVENTION

However, in light-emitting devices, heat generation occurs along with light emission of the light-emitting element, and therefore the temperature easily increases, and thus excellent heat-releasing characteristics are required. In the light-emitting device of Patent Document 1, heat generation of the light-emitting element can be released to the outside through the internal electrode from the positive electrode external connection land and the negative electrode external connection land. However, the positive electrode external connection land and the negative electrode external connection land are formed to be relatively small in light-emitting devices, and therefore improvement in heat-releasing characteristics is limited.

Furthermore, the light-emitting devices are also required to have excellent connectivity of the external connection wire to the positive electrode external connection land and the negative electrode external connection land. However, in the light-emitting device of Patent Document 1, the positive electrode external connection land and the negative electrode external connection land are formed to be relatively small, and therefore improvement in connectivity is limited.

An object of the present invention is to provide a light-emitting device having excellent heat-releasing characteristics and connectivity to wires; and a light-emitting device assembly and an electrode-bearing substrate for production thereof.

A light-emitting device of the present invention includes a substrate, an optical semiconductor element mounted on the surface of the substrate, an encapsulating layer formed on the substrate surface to encapsulate the optical semiconductor element, and an electrode formed on the substrate surface to be electrically connected to the optical semiconductor element, wherein on the substrate, only an encapsulating region and an electrode region are formed, the encapsulating region including the optical semiconductor element and being defined by the encapsulating layer, and the electrode region being defined by the electrode exposed from the encapsulating layer.

In the light-emitting device, on the substrate, only the encapsulating region and the electrode region are formed: in the encapsulating region, the optical semiconductor element is included and the encapsulating region is defined by the encapsulating layer, and the electrode region is defined by the electrode exposed from the encapsulating layer. That is, on the entire region other than the encapsulating region of the substrate, the electrode region is formed, and therefore because of excellent thermal conductivity of the electrode region, heat-releasing characteristics of the light-emitting device can be improved. Furthermore, the region other than the encapsulating region of the substrate is entirely the electrode region, and therefore because of a relatively large electrode region, wires can be easily and surely connected to the electrode region.

Thus, the light-emitting device is excellent in both heat-releasing characteristics and connectivity to wires.

The light-emitting device can be a small size.

In the light-emitting device of the present invention, it is preferable that the encapsulating region and/or the electrode region are formed continuously in one direction.

In the light-emitting device, the encapsulating region and/or the electrode region are formed continuously in one direction, and therefore the encapsulating region and/or the electrode region can be formed easily. Furthermore, because the electrode region is formed continuously in one direction, thermal conductivity of the electrode region is further improved, heat-releasing characteristics of the light-emitting device are further improved, and at the same time, connection to the electrode region can be simplified and ensured.

It is preferable that the light-emitting device of the present invention further includes a wire for connecting the optical semiconductor element to the electrode.

The light-emitting device further includes the wire, and therefore without providing an internal electrode to the substrate, the optical semiconductor element is connected to the electrode with the wire.

Thus, the substrate structure can be simplified. Therefore, the light-emitting device structure can be simplified.

In the light-emitting device of the present invention, it is preferable that the wire is encapsulated with the encapsulating layer.

In the light-emitting device, the wire is encapsulated with the encapsulating layer, and therefore reliability of the wire can be improved. Therefore, the light-emitting device is excellent in connection reliability.

The light-emitting device assembly of the present invention includes a plurality of the above-described light-emitting devices, the plurality of light-emitting devices each including a substrate, an optical semiconductor element mounted on the surface of the substrate, an encapsulating layer formed on the substrate surface to encapsulate the optical semiconductor element, and an electrode formed on the substrate surface to be electrically connected to the optical semiconductor element, wherein on the substrate, only an encapsulating region and an electrode region are formed, the encapsulating region including the optical semiconductor element and being defined by the encapsulating layer, and the electrode region being defined by the electrode exposed from the encapsulating layer.

The light-emitting device assembly includes a plurality of the above-described light-emitting devices, and therefore by singulating the plurality of light-emitting devices, a light-emitting device having excellent heat-releasing characteristics and connectivity can be efficiently produced.

An electrode-bearing substrate of the present invention is an electrode-bearing substrate for producing a light-emitting device comprising:
a substrate,
an optical semiconductor element mounted on the substrate surface,
an encapsulating layer formed on the substrate surface to encapsulate the optical semiconductor element, and
an electrode formed on the substrate surface to be electrically connected to the optical semiconductor element,
wherein on the substrate, only an encapsulating region and an electrode region are formed, the encapsulating region including the optical semiconductor element and being defined by the encapsulating layer, and the electrode region being defined by the electrode exposed from the encapsulating layer, and
the electrode-bearing substrate includes the substrate and the electrode formed on the substrate surface.

In the electrode-bearing substrate, when the light-emitting device is produced by forming an optical semiconductor element on the substrate surface, and forming the encapsulating layer on the substrate surface so as to encapsulate the optical semiconductor element, the substrate is formed with an encapsulating region in which the optical semiconductor element is included and which is defined by the encapsulating layer, and an electrode region defined by the electrode exposed from the encapsulating layer. That is, on the entire region other than the encapsulating region of the substrate, the electrode region is formed, and therefore because of excellent thermal conductivity of the electrode region, heat-releasing characteristics of the light-emitting device can be improved. Furthermore, the region other than the encapsulating region of the substrate is entirely the electrode region, and therefore because of a relatively large electrode region, wires can be easily and reliably connected to the electrode region.

Thus, a light-emitting device produced from the electrode-bearing substrate is excellent in both heat-releasing characteristics and connectivity to wires.

The light-emitting device of the present invention is excellent in both heat-releasing characteristics and connectivity to wires.

The light-emitting device assembly and the electrode-bearing substrate of the present invention allow for efficient production of a light-emitting device having excellent heat-releasing characteristics and connectivity.

### BRIEF DESCRIPTION OF THE DRAWINGS

FIG. 1 shows a plan view of a first embodiment of the light-emitting device assembly of the present invention.
FIG. 2 shows an enlarged plan view of the light-emitting device assembly shown in FIG. 1.
FIG. 3 shows an enlarged cross-sectional view of the light-emitting device assembly shown in

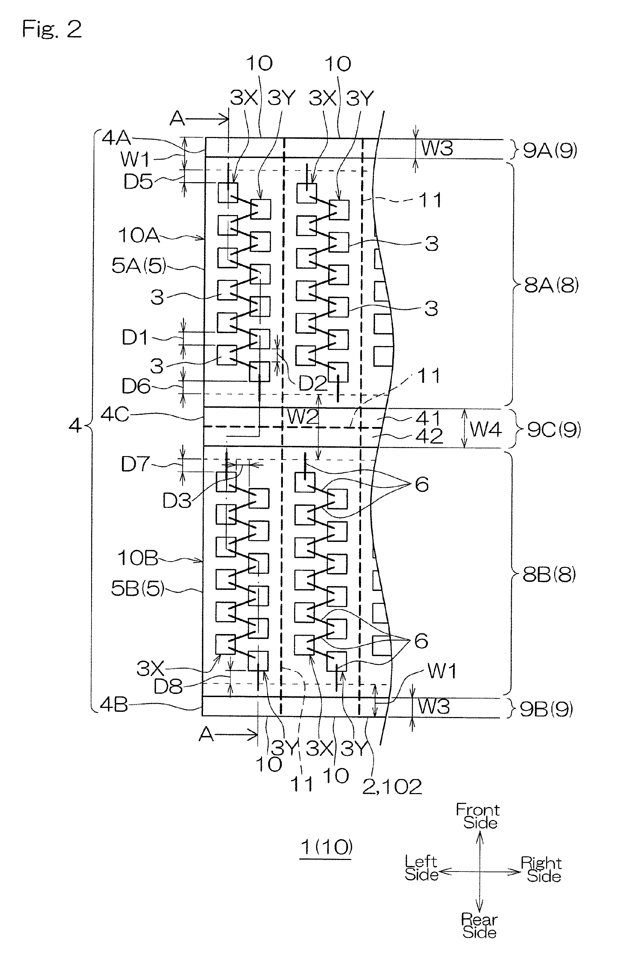

FIG. 2 along line A-A.

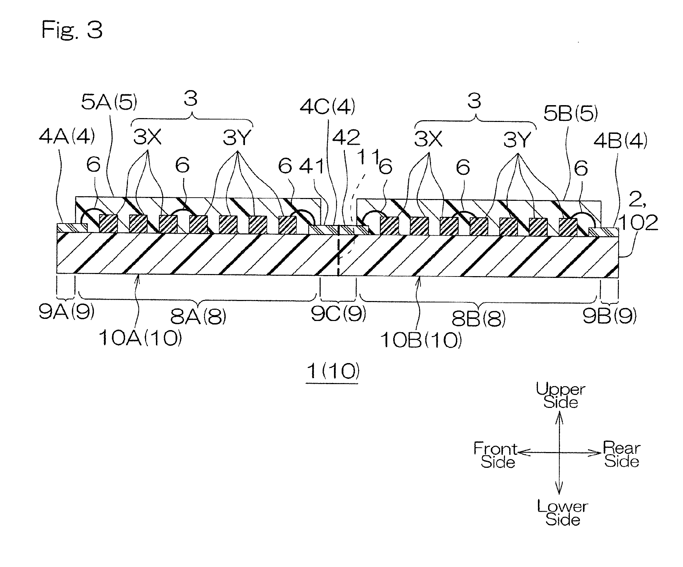

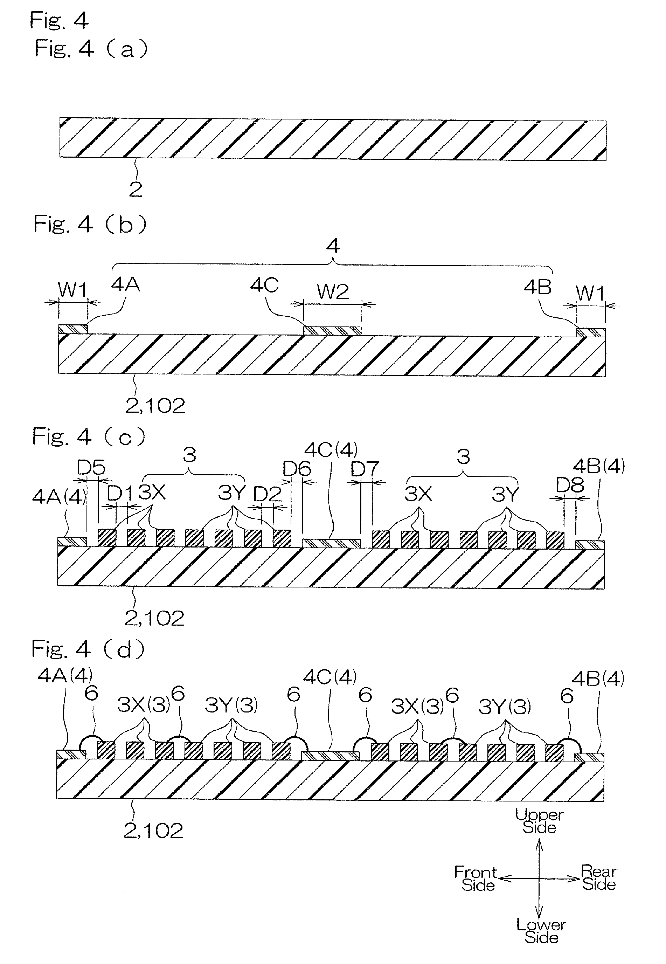

FIG. 4 shows cross-sectional views illustrating a method for producing the light-emitting device assembly shown in FIG. 3,
FIG. 4 (a) illustrating a step of preparing a substrate,
FIG. 4 (b) illustrating a step of forming electrodes,
FIG. 4 (c) illustrating a step of mounting optical semiconductor elements on the substrate, and
FIG. 4 (d) illustrating a step of electrically connecting electrodes, and electrically connecting the electrodes and optical semiconductor elements by wires.

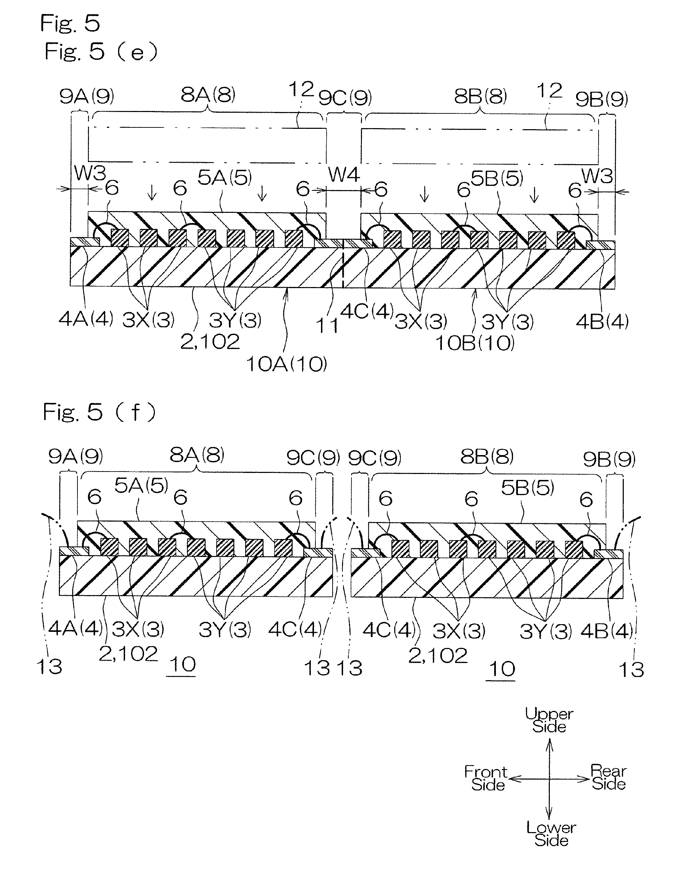

FIG. 5 shows, subsequent to FIG. 4, cross-sectional views illustrating the method for producing the light-emitting device assembly shown in FIG. 3,
FIG. 5 (e) illustrating a step of encapsulating optical semiconductor elements and wires with an encapsulating layer, and
FIG. 5 (f) illustrating a step of singulation of the light-emitting device assembly into light-emitting devices.

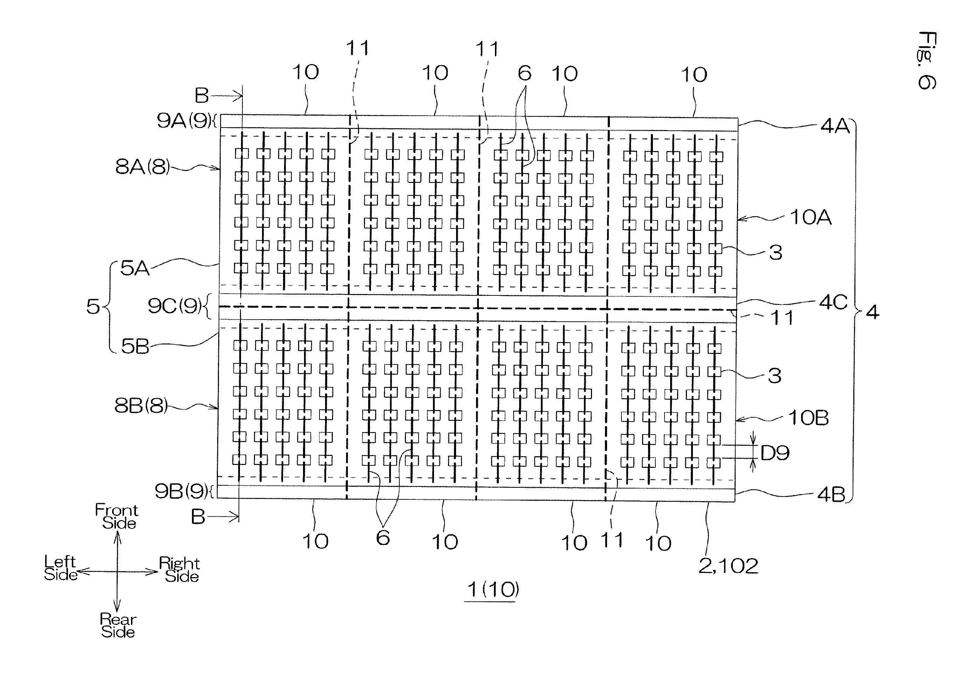

FIG. 6 shows a plan view of a second embodiment of the light-emitting device assembly of the present invention.

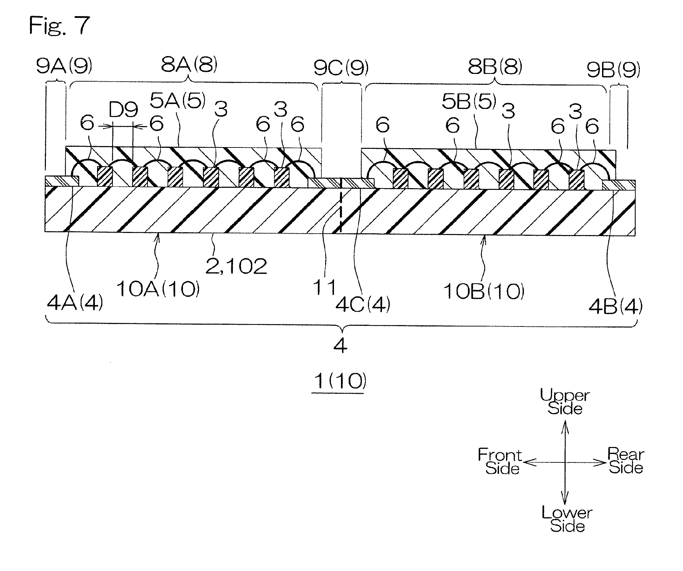

FIG. 7 shows an enlarged cross-sectional view of the light-emitting device assembly shown in
FIG. 6 along line B-B.

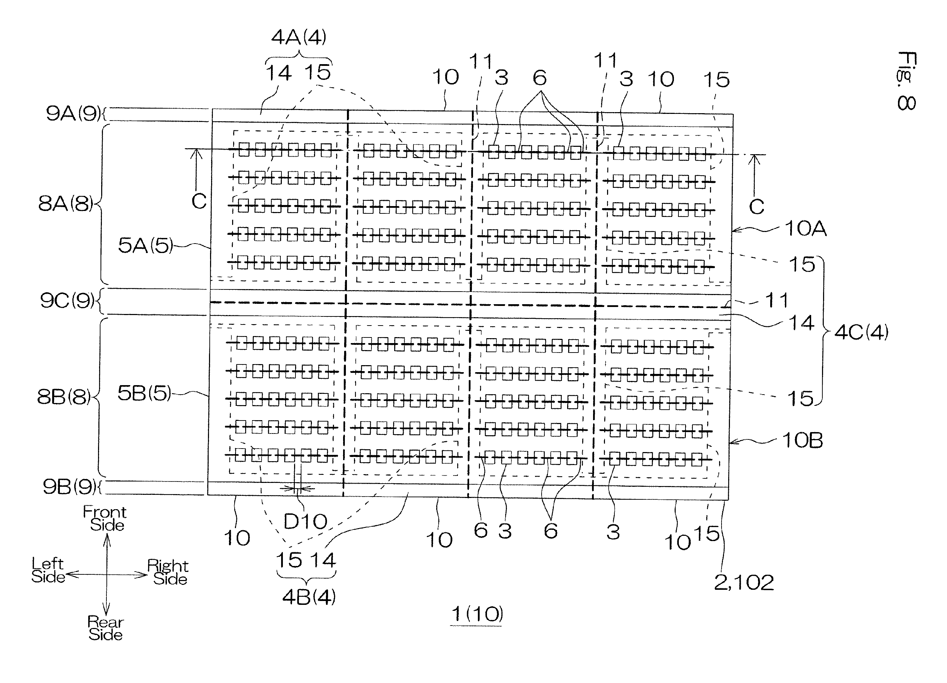

FIG. 8 shows a plan view of a light-emitting device assembly in a third embodiment of the present invention.

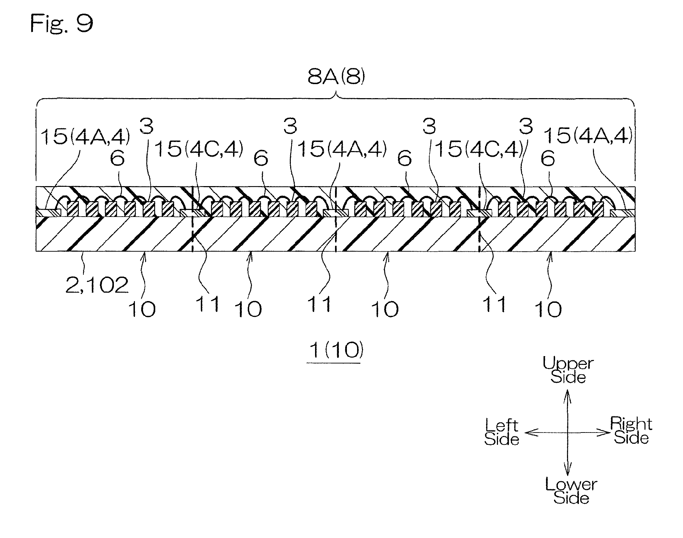

FIG. 9 shows an enlarged cross-sectional view along line C-C of the light-emitting device assembly shown in FIG. 8.

### DETAILED DESCRIPTION OF THE INVENTION

### <First Embodiment>

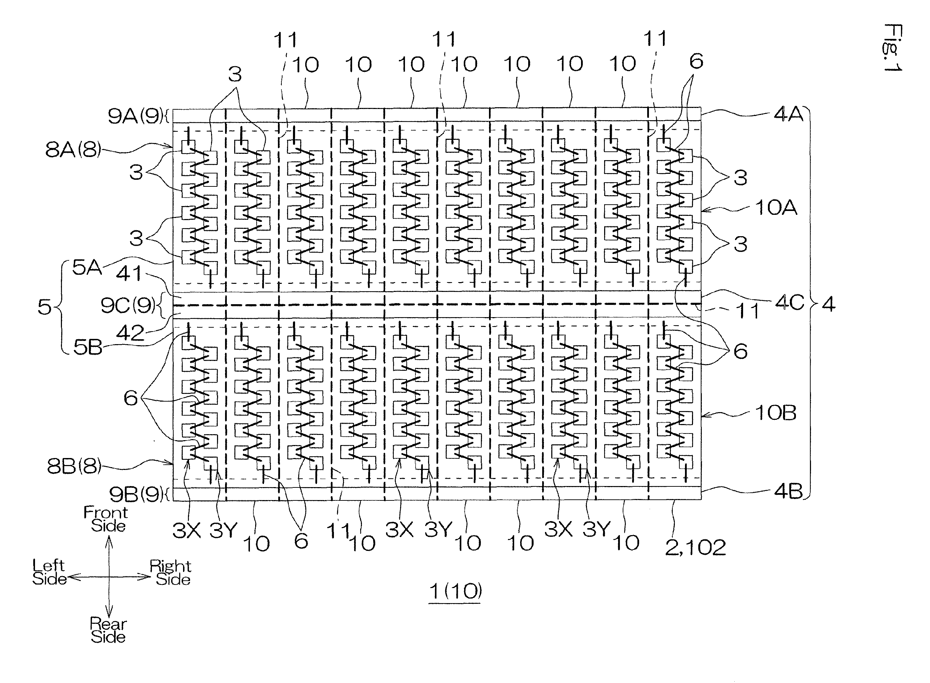

The directions in FIG. 1 are in conformity with the direction arrows in FIG. 1: the left-right directions in the plane of the paper are regarded as left-right directions (first direction), up-down directions in the plane of the paper are regarded as front-rear directions (second direction perpendicular to the first direction), and depth directions relative to the paper plane are regarded as up-down directions (third direction perpendicular to both directions of the first direction and the second direction). The directions in FIG. 2 and the following figures are in conformity with the directions in FIG. 1. In FIG. 1, the LEDs 3 and the wires 6 to be described later are covered with the encapsulating layer 5 described later, and therefore they are not visible when viewed from the top: however, to clearly show the positions of the LEDs 3 and the wires 6 relative to the encapsulating layer 5, they are shown with the solid line for convenience.

In FIG. 1, the light-emitting device assembly 1 extends in the front-rear directions and the left-right directions, has a generally rectangular shape when viewed from the top extending in the left-right directions, and is formed integrally from a plurality (e.g., 20) of light-emitting devices 10 provided continuously. In the light-emitting device assembly 1, the plurality of light-emitting devices 10 are arranged regularly in the left-right directions and the front-rear directions: to be specific, the plurality of light-emitting devices 10 are arranged in parallel to be next to each other, so that ten columns of the light-emitting devices 10 are arranged in the left-right directions, and two rows of the light-emitting devices 10 are arranged in the front-rear directions. Each of the light-emitting devices 10 is formed in a region that is generally rectangular shape when viewed from the top, with slits 11 (described later) shown in the bold broken line as a border.

The light-emitting device assembly 1 includes, as shown in FIGs. 1 and 3, a substrate 2; LEDs 3 as optical semiconductor elements mounted on the upper face (surface) of the substrate 2; and electrodes 4 that are formed on the upper face (surface) of the substrate 2 so as to be electrically connected to the LEDs 3.

The substrate 2 is formed into a generally rectangular flat plate shape when viewed from the top having the same outline shape as that of the light-emitting device assembly 1 when viewed from the top.

The LED 3 is formed into a generally rectangular flat plate shape when viewed from the top, and the plurality of LEDs 3 are provided in the light-emitting device assembly 1. The LEDs 3 are disposed on the upper face of the substrate 2 so as to ensure the region for forming the electrodes 4 to be described next. That is, LEDs 3 are provided in a region other than the front-end portion, the center portion in the front-rear directions, and the rear-end portion in the substrate 2. That is, the LEDs 3 are provided on the upper face of the substrate 2, at a center portion in the front-rear directions in the front-half portion, and at a center portion in the front-rear directions in the rear-half portion.

The plurality of LEDs 3 are zigzag-arranged regularly on the upper face of the substrate 2 in the left-right directions and in the front-rear directions in spaced-apart relation to each other.

To be specific, the LEDs 3 are provided, as shown in FIG. 2, in a plural number (e.g., 12) in each of the light-emitting devices 10. The LEDs 3 are provided in each of the light-emitting devices 10 in a plural number (e.g., 2 columns) in the left-right directions in spaced-apart relation to each other, and the LEDs 3 in each column are provided in a plural number (e.g., 6) in the front-rear directions in spaced-apart relation to each other. The LEDs 3X on the left column, and LEDs 3Y on the right column that are disposed on the right side relative to the LEDs 3X are disposed to be shifted in the front-rear directions when projected in the left-right directions. To be specific, the LEDs 3X in the left column are disposed to shift toward the front-side relative to the LEDs 3Y in the right column when projected in the left-right directions. In other words, the LEDs 3X in the left column are disposed on the left side obliquely frontward relative to the LEDs 3Y in the right column.

Furthermore, as shown in FIGs. 2 and 3, the light-emitting device assembly 1 includes wires 6 for electrically connecting the plurality of LEDs 3 in each of the light-emitting devices 10.

To be specific, the plurality (e.g., 6) of LEDs 3 in each of the light-emitting devices 10 are electrically connected in series with a plurality of (e.g., 5) wires 6. To be specific, in the light-emitting device 10, the wires 6 electrically connect the LEDs 3X in the left column and the LEDs 3Y in the right column one by one alternately, and in this manner, the arrangement in series made up of the LEDs 3 and the wires 6 is in a zigzag form in the front-rear directions. To be specific, at the front-side portion of each of the light-emitting devices 10, the foremost LED 3X of the left column, the wire 6, the foremost LED 3Y of the right column, the wire 6, and the LED 3X disposed at the rear-side of and next to the foremost LED 3X of the left column are electrically connected in series, and such connection is arranged repeatedly from the front-side toward the rear-side. Furthermore, at the rear-side portion of each of the light-emitting devices 10, the rearmost LED 3Y of the right column, the wire 6, the rearmost LED 3X of the left column, the wire 6, and LED 3Y disposed at the front-side of and next to the rearmost LED 3Y of the right column are electrically connected in series, and such connection is arranged repeatedly from the rear-side toward the front-side.

As shown in FIG. 1, the electrode 4 is formed into a generally rectangular shape extending in the left-right directions when viewed from the top (or generally straight line shape when viewed from the top) at each of the front-end portion, the center portion in the front-rear directions, and the rear-end portion of the substrate 2. Furthermore, as shown in FIG. 3, the front-end face of the electrode 4A at the front-end portion and the front-end face of the substrate 2 are formed so that they are disposed at the same position when viewed from the top. That is, they are formed to be flush with each other. The rear-end face of the rear-end portion of the electrode 4B and the rear-end face of the substrate 2 are formed so that they are disposed at the same position when viewed from the top. That is, the rear-end face of the rear-end portion of the electrode 4B and the rear-end face of the substrate 2 are formed so that they are flush with each other. The electrode 4C of the center portion in the front-rear directions is configured from a front-side portion 41 included in the light-emitting device 10A of the front row, and a rear-side portion 42 included in the light-emitting device 10B of the rear row disposed at the rear-side next to the light-emitting device 10A of the front row. The electrode 4C at the center portion in the front-rear directions is formed to be continuous in the front-rear directions (one direction) from the front-side portion 41 and the rear-side portion 42.

As shown in FIGs. 2 and 3, the electrodes 4 are electrically connected to the LEDs 3 through the wires 6. To be specific, in the light-emitting devices 10A in the front row, the electrode 4A at the front-end portion is electrically connected to the foremost LED 3X of the left column through the wire 6, and the electrode 4C at the center portion in the front-rear directions is electrically connected to the rearmost LED 3Y of the right column through the wire 6. Meanwhile, in the light-emitting device 10B of the rear row, the electrode 4C at the center portion in the front-rear directions is electrically connected to the foremost LED 3X of the left column through the wire 6, and the electrode 4B at the rear-end portion is electrically connected to the rearmost LED 3Y of the right column through the wire 6.

The wires 6 are connected to the rear-end edge of the upper face of the electrode 4A at the front-end portion, and the wires 6 are connected to the front-end edge of the upper face of the electrode 4B at the rear-end portion. Furthermore, the wires 6 are connected to both of the front-end edge and the rear-end edge of the upper face of the electrode 4C at the center portion in the front-rear directions.

The light-emitting device assembly 1 includes an encapsulating layer 5.

The encapsulating layer 5 is formed on the substrate 2 so as to encapsulate the plurality of LEDs 3. To be specific, the encapsulating layer 5 is formed continuously on the upper face (surface) of both of the front-side portion and the rear-side portion of the substrate 2 so as to extend in the left-right directions (one direction).

To be specific, the encapsulating layer 5 is provided in a plural number (e.g., 2) in spaced-apart relation in the front-rear directions, and as shown in FIG. 1, each of the encapsulating layers 5 is formed continuously extending in the left-right directions (one direction).

The front-side encapsulating layer 5A has a generally rectangular shape when viewed from the top extending long in the left-right directions, and is formed to cover each of the light-emitting devices 10A at the front row and the LEDs 3 and the wires 6 of the light-emitting devices 10 continuously. As shown in FIG. 3, the front-side encapsulating layer 5A is formed so as to cover the upper face and the side faces (front face, rear face, right side face, and left side face) of each of the LEDs 3 of the light-emitting device 10A at the front row, and at least the inner side face (that is, the rear-end face of the electrode 4A at the front-end portion, and the front-end face of the electrode 4C at the center portion in the front-rear directions shown in the thin broken line shown in FIG. 1 and FIG. 2) of the electrodes 4.

The front-side encapsulating layer 5A is formed to cover the rear-end edge of the upper face of the electrode 4A of the front-end portion, and to expose the front-end edge and the center portion in the front-rear directions of the upper face of the front-end portion electrode 4A. Furthermore, the front-side encapsulating layer 5A is formed to cover the front-end edge of the upper face of the electrode 4C at the center portion in the front-rear directions, and to expose the center portion in the front-rear directions of upper face of the electrode 4C at the center portion in the front-rear directions.

That is, as shown in FIGs. 2 and 3, the front-end face of the front-side encapsulating layer 5A is formed so as to extend in the left-right directions to overlap with the middle portion in the front-rear directions (slightly rear-side portion) of the electrode 4A of the front-end portion when projected in the thickness direction, and the rear-end face of the front-side encapsulating layer 5A is formed to extend in the left-right directions so as to overlap with the middle portion in the front-rear directions (slightly front-side portion) of the electrode 4C of the center portion in the front-rear directions when projected in the thickness direction.

In this manner, all of the LEDs 3 and all of the wires 6 are covered with the front-side encapsulating layer 5A in the light-emitting device 10A at the front row.

As shown in FIG. 1, the rear-side encapsulating layer 5B has a generally rectangular shape when viewed from the top extending long in the left-right directions, and is formed to continuously cover the light-emitting devices 10B of the rear row and the LEDs 3 and the wires 6 in each of the light-emitting device 10. As shown in FIG. 3, the rear-side encapsulating layer 5B is formed to cover on the upper face and the side faces (front face, rear face, right side face, and left side face) of LEDs 3 of the light-emitting device 10B of the rear row, and on at least inner side face (that is, front-end face of the electrode 4B at the rear-end portion and rear-end face of the electrode 4C at the center portion in the front-rear directions as shown in the thin broken line of FIG. 1 and FIG. 2) of the electrode 4.

The rear-side encapsulating layer 5B is formed to cover the front-end edge of the upper face of the electrode 4B of the rear-end portion and to expose the rear-end edge and the center portion in the front-rear directions of the upper face of the electrode 4B at the rear-end portion. Furthermore, the rear-side encapsulating layer 5B is formed to cover the rear-end edge of the upper face of the electrode 4C of the center portion in the front-rear directions, and to expose the center portion in the front-rear directions of the upper face of the electrode 4C at the center portion in the front-rear directions.

That is, the rear-end face of the rear-side encapsulating layer 5B is formed to extend in the left-right directions so as to overlap the middle portion in the front-rear directions (slightly front-side portion) of the electrode 4B of the rear-end portion when projected in the thickness direction, and the front-end face of the rear-side encapsulating layer 5B is formed to extend in the left-right directions so as to overlap the center portion in the front-rear directions (slightly rear-side portion) of the electrode 4C at the center portion in the front-rear directions at the rear side of the rear-end face of the front-side encapsulating layer 5A when projected in the thickness direction.

In this manner, all of the LEDs 3 and all of the wires 6 of the light-emitting device 10B of the rear row are covered with the encapsulating layer 5B at the rear-side.

On the substrate 2 of the light-emitting device assembly 1, only the encapsulating region 8 and the electrode region 9 are formed.

As shown in FIGs. 1 and 2, the encapsulating region 8 includes at least the LEDs 3 when viewed from the top. To be specific, the encapsulating region 8 includes all of the LEDs 3 and all of the wires 6, and is a region defined by the encapsulating layer 5. That is, the encapsulating region 8 is defined, when viewed from the top, by the peripheral end edge of the encapsulating layer 5.

That is, the encapsulating region 8 is formed from an encapsulating region 8A at the front-side and an encapsulating region 8B at the rear-side corresponding to the encapsulating layer 5A at the front-side and the encapsulating layer 5B at the rear-side, respectively, and the encapsulating region 8A at the front-side and the encapsulating region 8B at the rear-side are separated and defined into a plural number (e.g., 2) in the front-rear directions in spaced-apart relation, and each of the encapsulating region 8A at the front-side and the encapsulating region 8B at the rear-side is defined as a generally rectangular shape when viewed from the top extending continuously in the left-right directions.

Meanwhile, the electrode region 9 is an entire region in the substrate 2 other than the encapsulating region 8. To be specific, the electrode region 9 is a region defined by the electrode 4 exposed from the encapsulating layer 5 when viewed from the top.

To be specific, the electrode region 9 is formed from the electrode region 9A at the front-end portion, the electrode region 9B at the rear-end portion, and the electrode region 9C at the center portion in the front-rear directions corresponding to the electrode 4A at the front-end portion, the electrode 4B at the rear-end portion, and the electrode 4C at the center portion in the front-rear directions, respectively, exposed from the encapsulating layer 5. Each of the electrode region 9A at the front-end portion, the electrode region 9B at the rear-end portion, and the electrode region 9C at the center portion in the front-rear directions is defined as a generally rectangular shape extending continuously in the left-right directions when viewed from the top.

In this manner, on the substrate 2 of the light-emitting device assembly 1, a plurality of electrode regions 9 (e.g., three), and a plurality of encapsulating regions 8 (e.g., two) are formed into a stripe pattern. To be specific, the electrode regions 9 and the encapsulating regions 8 are arranged alternately in the front-rear directions, and two electrode regions 9 are arranged at both end portions of the front-rear directions.

Next, description is given below of a method for producing the light-emitting device assembly 1 with reference to FIG. 4 and FIG. 5.

In this method, as shown in FIG. 4 (a), first, a substrate 2 is prepared.

For the substrate 2, for example, substrates generally used for optical semiconductor devices including a substrate of ceramic such as alumina, a substrate of resin such as polyimide, and a metal core substrate in which metal plate is used as the core are used.

Next, in this method, as shown in FIG. 4 (b), the electrode 4 is formed into the above-described pattern.

Examples of the material that forms the electrode 4 include conductive materials such as silver, gold, copper, iron, platinum, and alloys thereof. Preferably, silver is used.

To form the electrode 4, for example, plating, application, and bonding of the conductor layer are used, and preferably, application is used. The application include printing, and a conductor paste (preferably, a silver paste containing silver) containing the above-described conductive material is applied (including printing), and thereafter, as necessary, dried to form the electrode 4 into the above-described pattern. Bonding of the conductor layer includes, for example, when the substrate 2 is composed of a substrate having a conductor portion such as a metal core substrate, a method in which the insulating layer (not shown) is laminated on the upper face of the substrate 2 in the same pattern as that of the electrode 4, and thereafter, a conductor layer molded in advance into a shape of the electrode 4 is bonded onto the insulating layer.

The size of the electrode 4 is suitably selected, and width W1 (length in the front-rear directions) of the electrode 4A at the front-end portion and the electrode 4B at the rear-end portion is, for example, 0.3 mm or more, preferably 1 mm or more, and for example, 5 mm or less, preferably 3 mm or less. The width W2 of the electrode 4C at the center portion in the front-rear directions is set, for example, larger than width W 1 of the electrode 4A at the front-end portion and the electrode 4B at the rear-end portion. To be specific, the width W2 is, for example, more than 1 time, preferably, 1.5 times or more, and for example, 5 times or less, preferably, 3 times or less of the width W1 of the electrode 4A at the front-end portion and the electrode 4B at the rear-end portion. To be specific, width W2 of the electrode 4C at the center portion in the front-rear directions is, for example, 0.3 mm or more, preferably 1 mm or more, and for example, 15 mm or less, preferably 9 mm or less.

The electrode 4 has a thickness of, for example, 1 µm or more, preferably 5 µm or more, and for example, 100 µm or less, preferably 50 µm or less.

An electrode-bearing substrate 102 including the substrate 2 and the electrode 4 formed on the upper face (surface) thereof is obtained in this manner.

Next, in this method, as shown in FIG. 4 (c), the LEDs 3 are mounted on the substrate 2 in the above-described arrangement.

The size and the pitch of the LEDs 3 are suitably set in accordance with use and purpose of the light-emitting device 10, and to be specific, distance in the front-rear directions (interval) D 1 of LEDs 3X of the left column, and distance in the front-rear directions (interval) D2 of the LEDs 3Y in the right column corresponding to the light-emitting device 10 are, for example, 0.3 mm or more, preferably 0.5 mm or more, and for example, 5 mm or less, preferably 3 mm or less.

As shown in FIG. 2, in each of the light-emitting devices 10, distance (interval) D3 between the LED 3X in the left column and LED 3Y in the right column in the left-right directions when projected in the front-rear directions is, for example, 0.3 mm or more, preferably 0.5 mm or more, and for example, 5 mm or less, preferably 3 mm or less.

At the front-side portion of each of the light-emitting devices 10, distance (interval) D5 between the LED 3X at the foremost in the left column and the electrode 4A at the front-end portion, and distance (interval) D6 between LED 3Y at the rearmost in the right column and the electrode 4C at the center portion in the front-rear directions is, for example, 0.3 mm or more, preferably 0.5 mm or more, and for example, 5 mm or less, preferably 3 mm or less. At the rear-side portion of each of the light-emitting devices 10, distance (interval) D7 between LED 3X at the foremost in the left column and the electrode 4C at the center portion in the front-rear directions, and distance (interval) D8 between the LED 3Y at the rearmost in right column and the electrode 4B at the rear-end portion is, for example, 0.3 mm or more, preferably 0.5 mm or more, and for example, 5 mm or less, preferably 3 mm or less.

The length in the front-rear directions and the length in the left-right directions of the LEDs 3 are not particularly limited, and can be decided in accordance with the target illuminance of the light-emitting device 10.

The LED 3 has a thickness of, for example, 1 µm or more, preferably 100 µm or more, and for example, 500 µm or less, preferably 200 µm or less.

Next, in this method, as shown in FIG. 4 (d), the wires 6 are electrically connected between the plurality of LEDs 3, and between the LEDs 3 and the electrodes 4 to achieve the above-described arrangement by, for example, ultrasonic joining. The height of the wires 6 is, that is, the distance between the upper end portion of the wire 6 and the upper face of the substrate 2 is, for example, 0.01 mm or more, preferably 0.1 mm or more, and for example, 1.0 mm or less, preferably 0.6 mm or less.

Next, in this method, as shown in FIG. 5 (e), the encapsulating layer 5 is formed into the above-described pattern.

To form the encapsulating layer 5 into the above-described pattern, for example, an encapsulating sheet 12 (phantom line) prepared from an encapsulating resin composition containing an encapsulating resin is formed in advance, and then the encapsulating sheet 12 is laminated on the substrate 2 to include a portion of the electrode 4, the LEDs 3, and the wire 6.

Examples of the encapsulating resin include a thermoplastic resin which is plasticized by heating, a thermosetting resin which is cured by heating, and an activation energy curable resin which is cured by irradiation of an activation energy ray (e.g., ultraviolet ray, electron ray, etc.).

Examples of the thermoplastic resin include vinyl acetate resin, ethylene-vinyl acetate copolymer (EVA), vinyl chloride resin, and an EVA-vinyl chloride resin copolymer.

Examples of the thermosetting resin and the activation energy ray-curable resin include silicone resin, epoxy resin, polyimide resin, phenol resin, urea resin, melamine resin, and unsaturated polyester resin.

For the encapsulating resin, preferably, a thermosetting resin is used, and more preferably, silicone resin is used.

Examples of the encapsulating resin composition containing silicone resin as the encapsulating resin include thermosetting silicone resin compositions such as a two-step curable silicone resin composition and a one-step curable silicone resin composition.

The two-step curable silicone resin composition is a thermosetting silicone resin that has a 2-stage reaction mechanism, is brought into B-stage (semi-cured) at the first-stage reaction, and is brought into C-stage (completely cured) at the second-stage reaction. Meanwhile, the one-step curable silicone resin is a thermosetting silicone resin that has a first stage reaction mechanism, and is completely cured at the first-stage reaction.

B-stage is a state between A-stage, in which the thermosetting silicone resin composition is liquid, and C-stage, in which the thermosetting silicone resin composition is completely cured, and is a state where curing and gelling progresses slightly, and the modulus of elasticity is smaller than the modulus of elasticity in C-stage.

Examples of the uncured two-step curable type silicone resin composition (before curing in the first step) include a condensation reaction-addition reaction curable silicone resin composition.

The condensation reaction-addition reaction curable silicone resin composition is a thermosetting silicone resin composition that can undergo condensation reaction and addition reaction by heating, to be more specific, is a thermosetting silicone resin composition that can undergo condensation reaction by heating and brought into B-stage (semi-cured), then by further heating, can undergo addition reaction (to be specific, for example, hydrosilylation reaction) and brought into C-stage (completely cured).

Examples of such a condensation reaction-addition reaction curable silicone resin composition include a first condensation reaction-addition reaction curable silicone resin composition containing a polysiloxane having silanol groups at both ends, alkenyl group-containing trialkoxysilane, organo hydrogen siloxane, a condensation catalyst, and a hydrosilylation catalyst; a second condensation reaction-addition reaction curable silicone resin composition containing a polysiloxane having silanol groups at both ends, an ethylene unsaturated hydrocarbon group-containing silicon compound (hereinafter referred to as ethylene silicon compound), an epoxy group-containing silicon compound, organo hydrogen siloxane, a condensation catalyst, and an addition catalyst (hydrosilylation catalyst); a third condensation reaction-addition reaction curable silicone resin composition containing a silicone oil having silanols at both ends, alkenyl group-containing dialkoxy alkylsilane, organo hydrogen siloxane, a condensation catalyst, and a hydrosilylation catalyst; a fourth condensation reaction-addition reaction curable silicone resin composition containing organopolysiloxane having at least two alkenylsilyl groups in one molecule, organopolysiloxane having at least two hydrosilyl groups in one molecule, a hydrosilylation catalyst, and a curing retarder; a fifth condensation reaction-addition reaction curable silicone resin composition containing a first organopolysiloxane having at least two ethylene unsaturated hydrocarbon groups and at least two hydrosilyl groups in combination in one molecule, a second organopolysiloxane not having an ethylene unsaturated hydrocarbon group but having at least two hydrosilyl groups in one molecule, a hydrosilylation catalyst, and a hydrosilylation suppresser; a sixth condensation reaction-addition reaction curable silicone resin composition containing a first organopolysiloxane having at least two ethylene unsaturated hydrocarbon groups and at least two silanol-groups in combination in one molecule, a second organopolysiloxane not having an ethylene unsaturated hydrocarbon group but at least two hydrosilyl groups in one molecule, a hydrosilylation retarder, and a hydrosilylation catalyst; a seventh condensation reaction-addition reaction curable silicone resin composition containing a silicon compound, and a boron compound, or an aluminum compound; and an eighth condensation reaction-addition reaction curable silicone resin composition containing polyaluminosiloxane and a silane coupling agent.

These condensation reaction-addition reaction curable silicone resin compositions may be used singly or in a combination of two or more.

For the condensation reaction-addition reaction curable silicone resin composition, preferably, the second condensation reaction-addition reaction curable silicone resin composition is used.

In the second condensation reaction-addition reaction curable silicone resin composition, the polysiloxane having silanol groups at both ends, the ethylene silicon compound, and the epoxy group-containing silicon compound are condensation materials (material subjected to condensation reaction), and the ethylene silicon compound and organo hydrogen siloxane are addition materials (material subjected to addition reaction).

Examples of the one-step curable silicone resin composition include addition reaction curable silicone resin composition.

The addition reaction curable silicone resin composition contains, for example, ethylene unsaturated hydrocarbon group-containing polysiloxane as a main component, and organo hydrogen siloxane as a cross-linking agent.

Examples of the ethylene unsaturated hydrocarbon group-containing polysiloxane include alkenyl group-containing polydimethylsiloxane, alkenyl group-containing polymethylphenylsiloxane, and alkenyl group-containing polydiphenylsiloxane.

Addition reaction curable silicone resin compositions are available, usually, with separate packages of ethylene unsaturated hydrocarbon group-containing polysiloxane and organo hydrogen siloxane. To be specific, the addition reaction curable silicone resin composition is provided as two components: A liquid containing a main component (ethylene unsaturated hydrocarbon group-containing polysiloxane), and B liquid containing a cross-linking agent (organo hydrogen siloxane). A known catalyst necessary for addition reaction of these is added to ethylene unsaturated hydrocarbon group-containing polysiloxane.

With such an addition reaction curable silicone resin composition, the main component (A liquid) and the cross-linking agent (B liquid) are mixed to prepare a mixture liquid, and in the step of molding into a shape of the encapsulating sheet 12 from the mixture liquid, ethylene unsaturated hydrocarbon group-containing polysiloxane and organo hydrogen siloxane undergo addition reaction, thereby curing the addition reaction curable silicone resin composition, and forming silicone elastomer (cured substance).

The encapsulating resin composition may contain, as necessary, phosphor and a filler in suitable proportions.

Examples of the phosphor include, for example, yellow phosphor that can convert blue light into yellow light. Examples of such a phosphor include, for example, a phosphor in which composite metal oxide or metal sulfide is doped with metal atoms such as cerium (Ce) and europium (Eu).

To be specific, examples of the phosphor include garnet phosphor having a garnet crystal structure such as Y₃Al₅O₁₂: Ce (YAG (yttrium-aluminum-garnet): Ce), (Y,Gd)₃Al₅O₁₂: Ce, Tb₃Al₃O₁₂: Ce, Ca₃Sc₂Si₃O₁₂: Ce, and Lu₂CaMg₂ (Si,Ge)₃O₁₂: Ce; silicate phosphor such as (Sr,Ba)₂SiO₄: Eu, Ca₃SiO₄Cl₂: Eu, Sr₃SiO₅: Eu, Li₂SrSiO₄: Eu, and Ca₃Si₂O₇: Eu; aluminate phosphor such as CaAl₁₂O₁₉: Mn and SrAl₂O₄: Eu; sulfide phosphor such as ZnS: Cu, Al, CaS: Eu, CaGa₂S₄: Eu, and SrGa₂S₄: Eu; oxynitride phosphor such as CaSi₂O₂N₂: Eu, SrSi₂O₂N₂: Eu, BaSi₂O₂N₂: Eu, and Ca-α-SiAlON; nitride phosphor such as CaAlSiN₃: Eu and CaSi₅N₈: Eu; and fluoride phosphor such as K₂SiF₆: Mn and K₂TiF₆: Mn. Preferably, garnet phosphor, more preferably, Y₃Al₅O₁₂: Ce is used.

Examples of the filler include silicone microparticles, glass, alumina, silica (fused silica, crystalline silica, ultrafine amorphous silica, hydrophobic ultrafine silica, etc.), titania, zirconia, talc, clay, and barium sulfate. These fillers may be used singly or in a combination of two or more. Preferably, silicone microparticles and silica are used.

To the encapsulating resin composition, for example, known additives such as a modifier, surfactant, die, pigment, discoloration inhibitor, and ultraviolet absorber can be added in a suitable proportion.

The encapsulating sheet 12 is composed of, for example, a thermosetting silicone resin composition before being completely cured, or after being completely cured, preferably, composed of a thermosetting silicone resin composition before being completely cured.

More preferably, when the thermosetting silicone resin composition is a two-step curable silicone resin composition, the encapsulating sheet 12 is composed of a 1st-step cured material of the two-step curable silicone resin composition, and when the thermosetting silicone resin composition is a one-step curable silicone resin composition, the encapsulating sheet 12 is composed of a uncured material (before curing) of the one-step curable silicone resin composition.

Particularly preferably, the encapsulating sheet 12 is composed of a 1 st-step cured material of the two-step curable silicone resin composition.

To form the encapsulating sheet 12, for example, the above-described encapsulating resin composition (as necessary including a fluorescent agent, filler, etc.) is applied on a release film (not shown) by a method such as casting, spin coating, and roll coating to give a suitable thickness into the above-described pattern, and as necessary heated. When the encapsulating sheet 12 contains the two-step curable silicone resin composition, the encapsulating sheet 12 is brought into B-stage (semi-cured).

In this manner, the encapsulating sheet 12 having the above-described pattern (that is, a pattern conforming to the encapsulating layer 5A at the front-side and the encapsulating layer 5B at the rear-side) in a sheet form is formed.

The encapsulating sheet 12 has a hardness, i.e., a compressive modulus of elasticity of, for example, 0.01MPa or more, preferably 0.04MPa or more, and for example, 1.0MPa or less, preferably 0.2MPa or less.

The encapsulating sheet 12 has a thickness of, without particular limitation, for example, 100 µm or more, preferably 300 µm or more, and for example, 2000 µm or less, preferably 1000 µm or less.

To form the encapsulating layer 5, as shown by the phantom line in FIG. 5 (e), the encapsulating sheet 12 is allowed to face the LEDs 3 and the wire 6 in up-down direction in spaced-apart relation, and then, as shown in the arrow, the encapsulating sheet 12 is descended (pressed down), thereby covering the LEDs 3 and the wire 6 with the encapsulating sheet 12.

Then, the encapsulating sheet 12 is pressed against and attached to the substrate 2. The pressing for attachment is performed, preferably, under a reduced-pressure environment. The pressing temperature is, for example, 0°C or more, preferably 15°C or more, and for example, 40°C or less, preferably 35°C or less. For the pressing for attachment, although not shown, a known presser is used.

Thereafter, for example, when the encapsulating sheet 12 contains a thermosetting resin, the encapsulating sheet 12 is cured by heat, thereby forming an encapsulating layer 5. To be specific, when the encapsulating sheet 12 contains a two-step curable silicone resin composition, the encapsulating sheet 12 is brought into C-stage (completely cured). To be more specific, the curing conditions are, when the two-step curable silicone resin composition contains a condensation-addition reaction curable silicone resin composition, conditions under which addition reaction (hydrosilylation reaction) progresses.

To be specific, the heating temperature is, for example, 80°C or more, preferably 100°C or more, and for example, 200°C or less, preferably 180°C or less, and the heating time is, for example, 0.1 hour or more, preferably 1 hour or more, and for example, 20 hours or less, preferably 10 hours or less.

In this manner, the encapsulating layer 5 can be formed, and a portion of the electrode 4, and the LED 3 and the wire 6 can be encapsulated with the encapsulating layer 5.

With this formation of the encapsulating layer 5, the encapsulating region 8 and the electrode region 9 are defined on the substrate 2.

W3 of the electrode region 9A at the front-end portion and the electrode region 9B at the rear-end portion is (length in the front-rear directions), in view of heat-releasing characteristics and connectivity (to be specific, soldering) between the wires 13 (described later), for example 0.5 mm or more, preferably 0.75 mm or more, and for example, 5 mm or less, preferably 3 mm or less. The electrode region 9C at the center portion in the front-rear directions has a width (length in the front-rear directions) W4 of, in view of heat-releasing characteristics and connectivity (to be specific, soldering) between the wires 13 (described later) of, for example, 1.0 mm or more, preferably 1.5 mm or more, and for example, 10 mm or less, preferably 6 mm or less.

In this manner, a light-emitting device assembly 1 can be produced.

Next, description is given below of a method for producing light-emitting devices 10 from the produced light-emitting device assembly 1.

To produce the light-emitting device 10, the light-emitting device assembly 1 is cut, as shown in FIG. 5 (e), along the slits 11 so as to singulate the light-emitting device assembly 1 into light-emitting devices 10. To cut the light-emitting device assembly 1, for example, dicing is used.

The slits 11 are formed, as shown in FIG. 1, so as to mark off the light-emitting device assembly 1. For example, the slits 11 are formed to mark off into 10 columns of the light-emitting devices 10 in the left-right directions, and two rows of the light-emitting devices 10 in the front-rear directions. To be specific, the slits 11 are formed along the front-rear directions so as to mark off each unit of the light-emitting device 10 composed of LED3X in the left column and LED3Y in the right column, and are formed along the left-right directions so as to transverse the center portion in the front-rear directions of the electrode region 9 in the left-right directions between the encapsulating layer 5A at the front-side and the encapsulating layer 5B at the rear-side.

In this manner, as shown in FIG. 5 (f), a plurality of (e.g., 20) light-emitting devices 10 are produced.

On the substrate 2 of the obtained light-emitting device 10, only the encapsulating region 8 and the electrode region 9 are formed. Each of the encapsulating region 8 and the electrode region 9 continues along one direction, that is, along the left-right directions.

Thereafter, to the electrode region 9 of the produced light-emitting device 10, as shown by the phantom line in FIG. 5 (f), one end portion of the wire 13 is electrically connected by, for example, ultrasonic joining. To the other end portion of the wire 13, a power source which is not shown is electrically connected, and in this manner, the LEDs 3 are connected to the power source (not shown) through the electrode region 9 and the wire 13. To the light-emitting device 10, electric power is supplied from the power source (not shown) through the wire 13, thus allowing the LEDs 3 to emit light.

In the light-emitting device 10, on the substrate 2, only the encapsulating region 8 including the LEDs 3 and defined by the encapsulating layer 5, and the electrode region 9 defined by the electrode 4 exposed from the encapsulating layer 5 are formed. That is, other than the encapsulating region 8 of the substrate 2, the electrode region 9 is formed entirely, and thus the electrode region 9 is excellent in thermal conductivity, and improvement in heat-releasing characteristics of the light-emitting device 10 can be achieved. Furthermore, other than the encapsulating region 8 of the substrate 2, the electrode region 9 is entirely formed, and thus the electrode region 9 is relatively large, and thus connection of the wires 13 to the electrode region 9 can be achieved easily and surely.

Thus, the light-emitting device 10 is excellent in both heat-releasing characteristics and connectivity to the wires.

The light-emitting device 10 can be small-sized.

Furthermore, in the light-emitting device 10, the encapsulating region 8 and the electrode region 9 are both formed continuously in one direction, to be specific, in left-right directions, and thus the encapsulating region 8 and the electrode region 9 can be formed easily. Furthermore, the electrode region 9 is formed continuously in the left-right directions, and thus thermal conductivity of the electrode region 9 can be improved furthermore, and heat-releasing characteristics of the light-emitting device 10 can be improved furthermore, and connection to the electrode region 9 can be achieved more easily and more certainly.

Furthermore, the light-emitting device 10 includes wires 6, and thus connection between the LEDs 3 and the electrode can be made through the wires 6 without providing the substrate 2 with internal electrodes.

Thus, the structure of the substrate 2 can be made simple. Thus, the light-emitting device 10 allows for simplification of the structure.

Furthermore, in the light-emitting device 10, the wires 6 are encapsulated with the encapsulating layer 5, and thus reliability of the wires 6 can be improved. Thus, the light-emitting device 10 has excellent connection reliability.

The light-emitting device assembly 1 includes a plurality of the above-described light-emitting devices 10, and therefore by singlation of the plurality of light-emitting devices 10, a light-emitting device 10 excellent in heat-releasing characteristics and connectivity can be produced efficiently.

In the electrode-bearing substrate 102 shown in FIG. 4 (b), by forming the LEDs 3 on the surface of the substrate 2, and by forming the encapsulating layer 5 on the surface of the substrate 2 so as to encapsulate the LEDs 3 to produce the light-emitting device 10, on the substrate 2, only the encapsulating region 8 including the LEDs 3 and defined by the encapsulating layer 5, and the electrode region 9 defined by the electrode 4 exposed from the encapsulating layer 5 are formed. That is, on the entire region other than the encapsulating region 8 of the substrate 2, the electrode region 9 is formed, and therefore because of excellent thermal conductivity of the electrode region 9, heat-releasing characteristics of the light-emitting device 10 can be improved. Furthermore, the region other than the encapsulating region 8 of the substrate 2 is entirely the electrode region 9, and therefore because of a relatively large electrode region 9, wires 13 can be easily and surely connected to the electrode region 9.

Thus, the light-emitting device 10 produced from the electrode-bearing substrate 102 is excellent in both heat-releasing characteristics and connectivity to the wires.

### <Modification>

In the first embodiment, the light-emitting device assembly 1 including a plurality of light-emitting devices 10 is cut for singulation of the light-emitting device 10, but for example, the light-emitting device assembly 1 can also be used as is as a light-emitting device 10 without cutting or singulation.

In such a case, one end portion of the wire is electrically connected to each of the electrodes 4, that is, to each of the electrode 4A at the front-end portion, the electrode 4B at the rear-end portion, and the electrode 4C at the center portion in the front-rear directions.

In the first embodiment, as shown in FIG. 1, the slits 11 along the front-rear directions are formed so as to partition per unit composed of the LEDs 3X in the left column and the LEDs 3Y in the right column, but for example, although not shown, can also be formed so as to partition per a plurality of units.

In the first embodiment, the wires 6 electrically connect the plurality of LEDs 3 in each of the light-emitting devices 10, but for example, although not shown, internal electrodes can be provided on the substrate 2, and the LEDs 3 are electrically connected not through the wire 6 but through the internal electrodes of the substrate 2.

Furthermore, in the first embodiment, the electrode 4 and the LEDs 3 are electrically connected through the wires 6 in each of the light-emitting devices 10, but for example, although not shown, internal electrode can be provided in the substrate 2, and the electrode 4 and the LEDs 3 can be electrically connected not through the wire 6 but through the internal electrode of the substrate 2.

In the first embodiment, in each of the light-emitting devices 10, two LEDs 3 are arranged in the left-right directions, and six LEDs 3 are arranged the front-rear directions (2 × 6), but the number and arrangement of the LEDs 3 are not limited to the above-described one. For example, although not shown, only one LED 3 can be provided in each of the light-emitting devices 10.

Furthermore, in the first embodiment, the encapsulating layer 5 is formed from the encapsulating sheet 12 shown in the phantom line of FIG. 5 (e), but for example, the encapsulating layer 5 can also be formed by potting the above-described encapsulating resin composition. In the potting, a protection member such as a dam member (not shown) is set in advance in a region corresponding to the electrode region 9, and while protecting the region corresponding to the electrode region 9, the encapsulating layer 5 is formed and then the protection member is removed.

Preferably, the encapsulating layer 5 is formed from the encapsulating sheet 12. By forming the encapsulating sheet 12 from the encapsulating layer 5, the steps of setting and removing the protection member are unnecessary, and to that extent, the encapsulating layer 5 can be formed easily.

In the first embodiment, as shown in FIG. 4, the electrodes 4 (ref: FIG. 4 (b)) are provided, and thereafter, the LEDs 3 and the wires 6 are sequentially provided (ref: FIG. 4 (c) and FIG. 4 (d)) but the sequence is not particularly limited. For example, although not shown, the LEDs 3 and the wires 6 can be sequentially provided, and thereafter, the electrodes 4 can be provided.

In the first embodiment, the LEDs 3 are given as an example of the optical semiconductor element of the present invention for illustration, but for example, LD (laser diode) 3 can also be used as the optical semiconductor element of the present invention.

### <Second Embodiment>

In FIGs. 6 and 7, the members that are the same with those of the first embodiment are given with the same reference numbers, and detailed descriptions thereof are omitted.

As shown in FIGs. 6 and 7, the LEDs 3 and the wire 6 arranged in series can also be formed into a generally linear form along the front-rear directions.

In each of the light-emitting devices 10, the LEDs 3 that are arranged in series in the front-rear directions are provided in a plural number (e.g., 5 columns) in spaced-apart relation in the width direction.

The Second Embodiment also achieves the same operations and effects as those of the first embodiment.

Meanwhile, in the first embodiment, as shown in FIGs. 1 and 2, the LEDs 3 are arranged in a zigzag manner, to be specific, and the LEDs 3X in the left column are disposed at shifted positions when projected in the left-right directions relative to the LEDs 3Y in the right column. Thus, in the first embodiment, as shown in FIG. 6, compared with the second embodiment in which the LEDs 3 are arranged along the front-rear directions and the left-right directions, thermal load per LED 3 can be reduced, that is, heat-releasing characteristics from the LEDs 3 can be improved. Thus, the first embodiment is a preferable embodiment compared with the second embodiment.

### <Modification>

In the second embodiment, as shown in FIG. 6, in each of the light-emitting devices 10, the LEDs 3 arranged in series in the front-rear directions are provided in a plural number (e.g., 5 columns), but for example, although not shown, the LEDs 3 arranged in series in the front-rear directions can be provided in a minimum column, to be specific, one column.

### <Third Embodiment>

In FIGs. 8 and 9, the members that are the same with those of the first embodiment and the second embodiment are given with the same reference numbers, and detailed descriptions are omitted.

In the first embodiment and the second embodiment, as shown in FIGs. 1 and 6, the electrode 4 is formed into a generally rectangular shape extending in the left-right directions when viewed from the top (or generally straight line shape when viewed from the top), but in the third embodiment, the electrode 4 can also be formed into a generally comb shape when viewed from the top.

In the second embodiment, the arrangement in series made of the LEDs 3 and the wires 6 is formed along the front-rear directions, but in the third embodiment, these arrangement in series can be formed along the left-right directions.

As shown in FIGs. 8 and 9, in the each of the light-emitting devices 10, the LEDs 3 that are arranged in series along the left-right directions are arranged in a plural number (e.g., 5 rows) in the front-rear directions in spaced-apart relation.

Each of the electrodes 4A at the front-end portion and the electrodes 4C at the center portion in the left-right directions (portion corresponding to the light-emitting device 10A of the front row) is formed into a comb shape, and to be specific, integrally includes a base portion 14 extending in the left-right directions, and an extended portion 15 (thin broken line) extending from the base portion 14 in the front-rear directions. The electrode 4A at the front-end portion and the electrode 4C at the center portion in the front-rear directions are provided in the front-rear directions in spaced-apart relation. Then, the electrode 4A at the front-end portion and the electrode 4C at the center portion in the front-rear directions are disposed in a staggered manner. That is, the extended portions 15 are arranged so that they face each other in the left-right directions in spaced-apart relation, to be specific, the extended portion 15 of the electrode 4A at the front-end portion and the extended portion 15 of the electrode 4C at the center portion in the front-rear directions are disposed alternately in the left-right directions.

Each of the electrode 4B at the rear-end portion and the electrode 4C at the center portion in the front-rear directions (portion corresponding to the light-emitting device 10B of the rear row) is formed into a comb shape, and to be specific, integrally includes the base portion 14 extending in the left-right directions and the extended portion 15 (thin broken line) extending from the base portion 14 in the front-rear directions. The electrode 4B at the rear-end portion and the electrode 4C at the center portion in the front-rear directions are provided in the front-rear directions in spaced-apart relation. The electrode 4B at the rear-end portion and the electrode 4C at the center portion in the front-rear directions are disposed in a staggered manner. That is, the extended portions 15 are disposed so that they face each other in the left-right directions in spaced-apart relation, to be specific, the extended portion 15 of the electrode 4B at the rear-end portion and the extended portion 15 of the electrode 4C at the center portion in the front-rear directions are disposed alternately in the left-right directions.

Then, in each of the light-emitting devices 10, the rightmost LED 3 and the leftmost LED 3 are connected through the wire 6 to the extended portion 15 of the electrode 4 (to be specific, the electrode 4A at the front-end portion or the electrode 4B at the rear-end portion).

Third embodiment also achieves the same operations and effects of the first embodiment and the second embodiment.

Meanwhile, in the third embodiment, as shown in FIG. 8, the electrode 4 is formed into a generally comb shape when viewed from the top including the extended portion 15, and thus compared with the first embodiment and the second embodiment, in which the electrode 4 does not include the above-described extended portion 15 and is formed into a generally straight line when viewed from the top as shown in FIG. 1 and FIG. 6, the space for mounting the LEDs 3 is small, and the distance (interval) between the LEDs 3 in each row is formed to be short.

Thus, the first embodiment and the second embodiment are preferable embodiments compared with the third embodiment because their LEDs 3 are excellent in heat-releasing characteristics.

### <Modification>

In the third embodiment, in each of the light-emitting devices 10, as shown in FIG. 8, the LEDs 3 that are arranged in series in the left-right directions are provided in a plural number (e.g., 5 rows), but for example, although not shown, the row can also be provided in the minimum number, to be specific, one row.

While the illustrative embodiments of the present invention are provided in the above description, such is for illustrative purpose only and it is not to be construed as limiting the scope of the present invention. Modifications and variations of the present invention that will be obvious to those skilled in the art are to be covered by the following claims.

## Claims

1. A light-emitting device assembly comprising:
a substrate, an optical semiconductor element mounted on the surface of the substrate, an encapsulating layer formed on the substrate surface to encapsulate the optical semiconductor element, and an electrode formed on the substrate surface to be electrically connected to the optical semiconductor element,
wherein on the substrate, only an encapsulating region and an electrode region are formed,
the encapsulating region including the optical semiconductor element and being defined by the encapsulating layer, and
the electrode region being defined by the electrode exposed from the encapsulating layer.

2. The light-emitting device according to Claim 1, wherein the encapsulating region and/or the electrode region is formed continuously in one direction.

3. The light-emitting device according to Claim 1, further comprising a wire for connecting the optical semiconductor element to the electrode.

4. The light-emitting device according to Claim 3, wherein the wire is encapsulated with the encapsulating layer.

5. A light-emitting device assembly comprising a plurality of light-emitting devices, the plurality of light-emitting devices each comprising
a substrate,
an optical semiconductor element mounted on the surface of the substrate,
an encapsulating layer formed on the substrate surface to encapsulate the optical semiconductor element, and
an electrode formed on the substrate surface to be electrically connected to the optical semiconductor element,
wherein on the substrate,
only an encapsulating region and an electrode region are formed,
the encapsulating region including the optical semiconductor element and being defined by the encapsulating layer, and the electrode region being defined by the electrode exposed from the encapsulating layer.

6. An electrode-bearing substrate for producing a light-emitting device, the light-emitting device comprising:
a substrate,
an optical semiconductor element mounted on the surface of the substrate,
an encapsulating layer formed on the substrate surface to encapsulate the optical semiconductor element, and
an electrode formed on the substrate surface to be electrically connected to the optical semiconductor element,
wherein on the substrate,
only an encapsulating region and an electrode region are formed,
the encapsulating region including the optical semiconductor element and being defined by the encapsulating layer, and the electrode region being defined by the electrode exposed from the encapsulating layer, and
the electrode-bearing substrate comprises the substrate, and the electrode formed on the substrate surface.
